Europäisches Patentamt

European Patent Office

Office européen des brevets

(19)

(11) **EP 1 031 172 B1**

(12) **FASCICULE DE BREVET EUROPEEN**

(45) Date de publication et mention
de la délivrance du brevet:
**22.05.2002 Bulletin 2002/21**

(21) Numéro de dépôt: **98955645.1**

(22) Date de dépôt: **13.11.1998**

(51) Int Cl.⁷: $H01Q\ 3/26$, $H04B\ 10/145$

(86) Numéro de dépôt international:
**PCT/FR98/02419**

(87) Numéro de publication internationale:
**WO 99/26312 (27.05.1999 Gazette 1999/21)**

(54) **REALISATION D'EMETTEURS HYPERFREQUENCES ET APPLICATIONS AUX RADARS ET AUX TELECOMMUNICATIONS**

SENDEEINRICHTUNG FÜR MIKROWELLEN UND ANWENDUNG FÜR RADAR UND TELEKOMMUNIKATION

PRODUCTION OF MICROWAVE TRANSMITTERS AND APPLICATIONS TO RADAR AND TELECOMMUNICATIONS

(84) Etats contractants désignés:
**DE GB IT**

(30) Priorité: **14.11.1997 FR 9714301**

(43) Date de publication de la demande:
**30.08.2000 Bulletin 2000/35**

(73) Titulaire: **COMMISSARIAT A L'ENERGIE ATOMIQUE**
**75015 Paris (FR)**

(72) Inventeurs:
• **GIDON, Serge**
  **F-33140 La Murette (FR)**
• **MOLVA, Engin**
  **F-38000 Grenoble (FR)**
• **THONY, Philippe**
  **F-38500 La Buisse (FR)**

(74) Mandataire: **Ilgart, Jean-Christophe et al**
  **c/o Brevatome,**
  **3, rue du Docteur Lancereaux**
  **75008 Paris (FR)**

(56) Documents cités:
EP-A- 0 724 316          EP-A- 0 793 291
WO-A-90/09688          US-A- 4 739 334
US-A- 5 307 073          US-A- 5 374 935

• PATENT ABSTRACTS OF JAPAN vol. 011, no. 081 (E-488), 12 mars 1987 & JP 61 234633 A (NEC CORP), 18 octobre 1986

## Description

### DOMAINE TECHNIQUE ET ART ANTERIEUR

L'invention concerne le domaine des sources optiques, et leur utilisation en tant que composants dans des matrices d'émetteurs hyperfréquences.

Des émetteurs hyperfréquences mettant en oeuvre des sources optiques sont utilisés dans le domaine des télécommunications opto-hyperfréquence, comme décrit dans le document de G. Grosskopf intitulé "Optical fibres deliver microwave broadcasts" paru dans O.L.E., Septembre 1996, p.55-61.

Une des applications possibles de l'invention est donc la "radiotéléphonie picocellulaire" avec l'utilisation du réseau de télécommunication fibré comme canal de transport de l'information jusqu'aux points rayonnants.

La génération de signaux hyperfréquence par hétérodynage de signaux optiques requiert des sources lumineuses du type des sources laser, décalées en fréquence de la valeur de la fréquence hyper recherchée.

Ce décalage en fréquence peut être obtenu de différentes manières :

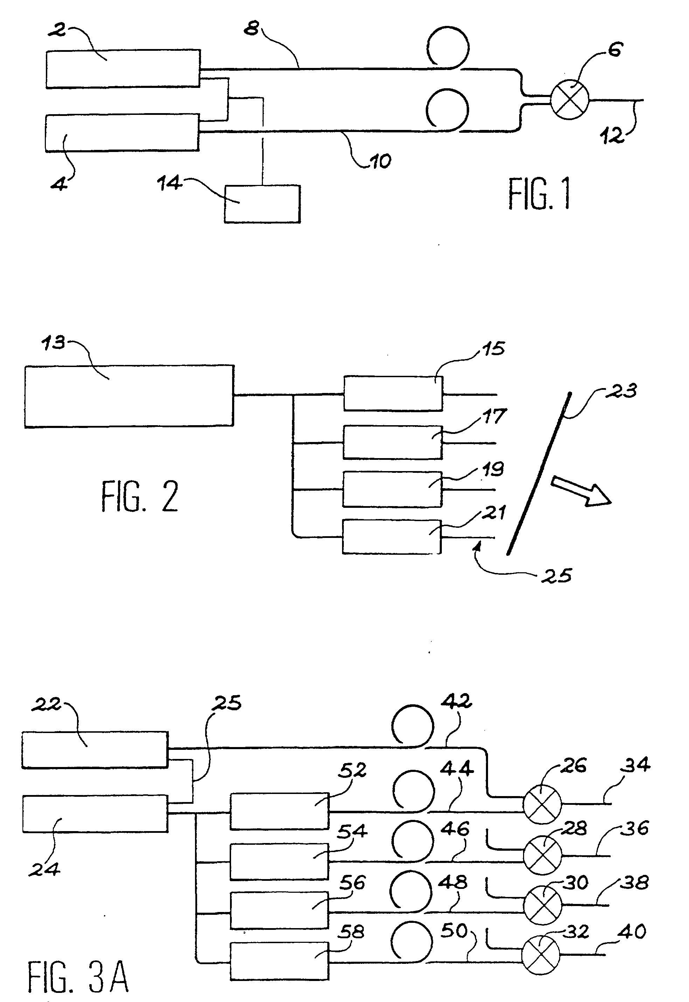

> a) avec deux lasers, on peut obtenir, si ceux-ci ont des longueurs optiques de cavité légèrement différentes, deux émetteurs à longueurs d'onde légèrement décalées, et donc à fréquence d'émission pouvant différer de celle du signal hyperfréquence à générer.
>
> Ce principe du transport optique de signaux hyperfréquences est rappelé sur la figure 1.
>
> Deux sources optiques 2, 4, émettent respectivement un rayonnement à la fréquence $\Omega$ et $\Omega+\omega$ et sont couplées à un mélangeur 6 (une photodiode) par l'intermédiaire de fibres optiques 8, 10. La partie 12, située au-delà du mélangeur, forme l'antenne. Un dispositif 14 permet en outre d'asservir les deux lasers en fréquence.
>
> b) Au sein d'une unique cavité laser, il est possible de faire coexister simultanément deux modes d'oscillation (avec des états de polarisation orthogonaux, linéaires ou circulaires), dont l'écart en fréquence est ajustable à la valeur de la fréquence hyper recherchée. Un tel système est par exemple décrit dans le document de M. Brunel et al. intitulé "Differential measurement of the coupling constant between laser eigenstates" paru dans Applied Physics Letters, vol.70, n° 16, Avril 1997.

D'autres méthodes sont connues, comme l'emploi d'un décaleur de fréquence optique (typiquement, un modulateur acousto-optique) pour obtenir deux sources décalées en fréquence. Cette technique n'est pas compatible avec les fréquences recherchées ($\simeq$10 Ghz).

Tous les dispositifs connus posent un problème d'encombrement.

De plus, dans les dispositifs connus, des dispositifs de correction sont nécessaires du fait de la trop grande largeur spectrale du signal optique.

Enfin, les diodes laser, utilisées dans la plupart des cas, sont en général modulées en fréquence par leur courant d'alimentation, et donc aussi, simultanément, en amplitude d'émission.

Un autre exemple de domaine d'application de l'invention est le domaine des radars.

Les radars modernes utilisent un concept dit d'antenne active dans lequel la fonction de balayage angulaire de l'antenne n'est pas obtenue par rotation de l'antenne proprement dite mais par celle de son plan d'onde d'émission. Le plan d'onde résulte d'une mise en phase - dans la direction recherchée - d'ondes élémentaires issues de divers éléments rayonnants de l'antenne. La mise en phase est généralement obtenue par l'ajustement de retards sur les voies de transports des différents signaux hyperfréquence. La figure 2 présente schématiquement ce principe.

Le rayonnement produit par un émetteur 13 est divisé en n faisceaux traversant chacun des moyens 15, 17, 19, 21 pour leur imposer un retard. L'onde 23 émise par les antennes 25 voit son plan d'onde modifié en fonction des différents retards imposés.

La nécessité de disposer d'un nombre de plus en plus important d'éléments rayonnants de l'antenne afin d'améliorer, notamment, la résolution angulaire (on parle de 2000 émetteurs) ainsi que le besoin d'assurer une gestion précise des retards conduisent à une complexité du système difficilement maîtrisable avec les techniques classiques en hyperfréquences (encombrements et poids incompatibles avec le besoin de certains dispositifs, aéroportés notamment).

US 5 307 073 A décrit un dispositif émetteur d'hyperfréquences. EP 0 793 291 A décrit une antenne à ondes millimétriques utilisant une lentille de Rotman et un système hétérodyne optique, et US 5 374 935 A décrit un système d'antenne à réseau commandé optiquement.

### EXPOSÉ DE L'INVENTION

La présente invention concerne l'utilisation de composants en matrice, dans des technologies de fabrication planaire et collective pour la réalisation d'émetteurs hyperfréquences.

L'invention concerne en particulier un dispositif émetteur d'hyperfréquences, comportant :

- une pluralité de N paires d'émetteurs laser, réalisés en mosaïque ou en matrice ou en barrette, chaque paire d'émetteurs laser comportant un premier et un second émetteurs laser émettant à une première et une deuxième fréquences $\omega_1$, $\omega_2$, différentes,
- une matrice ou une barrette de N éléments, chacun d'entre eux étant disposé sur le trajet du second émetteur laser d'une desdites paires d'émetteurs laser, et chaque élément permettant d'imposer un retard de phase au faisceau dudit second émetteur laser,

- des moyens d'asservissement, en fréquence et en phase de chaque paire d'émetteurs laser,
- N moyens pour mélanger chacun des faisceaux émis par les premiers émetteurs des N paires d'émetteurs laser avec chacun des faisceaux émis par les seconds émetteurs des N paires d'émetteurs laser et retardés par les éléments permettant d'imposer un retard de phase, et pour produire N signaux à la fréquence $\omega_1$-$\omega_2$,
- N moyens formant antenne pour émettre un rayonnement à la fréquence $\omega_1$-$\omega_2$.

L'invention repose sur un principe de génération d'onde électromagnétique hyperfréquence (fréquence pouvant atteindre plusieurs centaines de Ghz) au moyen du battement -de l'hétérodynage - d'au moins 2 ondes électromagnétiques dans le domaine optique (de fréquences bien plus élevées, de l'ordre de $10^{14}$Hz), engendrées par des lasers. L'utilisation d'éléments en mosaïque ou en matrice, pour imposer des retards de phase, permet la réalisation d'un dispositif compact.

La détection du battement de fréquences (fonction de mélange) est généralement assurée par une photodiode dont le courant est une fonction non linéaire du champ électromagnétique.

Un des intérêts de l'invention est la possibilité de "transporter" des signaux hyperfréquences avec une faible atténuation, linéique grâce à une "porteuse" optique. L'atténuation linéique dans les fibres n'est en effet que de l'ordre de 0,1 dB/km alors qu'elle est de 0,1 dB/m dans un conducteur hyperfréquence (coaxial).

Selon un autre aspect, les sources laser peuvent être des microlasers ou des VCSEL (laser à semiconducteur à cavité verticale). Ces composants sont eux aussi compatibles avec une réalisation collective, sous forme par exemple de mosaïques ou de matrices.

Le dispositif selon l'invention ne nécessite alors pas de dispositif de correction du signal reçu.

En effet, les sources laser puce (ou microlasers) ont une largeur de raie d'émission très faible, de l'ordre de quelques centaines de Khz, bien inférieure à celle de diodes laser (Mhz) ou celle des VCSEL (Mhz aussi).

D'autre part, les lasers puce sont modulables en fréquence d'émission (optique) sans "modulation d'amplitude croisée" (ce qui n'est pas le cas des diodes laser qui sont en général modulées en fréquence par leur courant d'alimentation, donc aussi en amplitude d'émission). Cette modification de fréquence est par exemple obtenue par modulation de type électro-optique de la longueur optique de la cavité microlaser.

L'invention concerne également un dispositif émetteur d'hyperfréquences, comportant :

- une pluralité de N paires d'émetteurs laser, réalisés en mosaïque ou en matrice ou en barrette, chaque paire d'émetteur laser comportant un premier et un second émetteurs laser émettant à une première et une deuxième fréquences $\omega_1$, $\omega_2$, différentes,
- des moyens pour asservir en fréquence chaque paire d'émetteurs laser,
- des moyens pour modifier la fréquence d'un des émetteurs laser d'au moins une paire d'émetteur laser par rapport à la fréquence de l'autre émetteur laser de ladite paire d'émetteurs laser,
- N moyens pour mélanger chacun des faisceaux émis par les premiers émetteurs des N paires d'émetteurs laser avec chacun des faisceaux émis par les seconds émetteurs des N paires d'émetteurs laser et pour produire un signal à la fréquence $\omega_1$-$\omega_2$,
- N moyens formant antenne pour émettre un rayonnement à la fréquence $\omega_1$-$\omega_2$.

Ce dispositif présente lui aussi une bonne compacité, du fait de la structure en barrette ou en mosaïque ou en matrice des émetteurs laser. De plus, l'utilisation de moyens pour modifier la fréquence d'un des émetteurs laser par rapport à la fréquence de l'autre émetteur permet d'obtenir un glissement de la phase d'un des émetteurs laser par rapport à la phase de l'autre émetteur laser. Il n'est alors plus nécessaire d'utiliser des moyens spécifiques de variation des phases des faisceaux émis par les lasers, comme dans les modes de réalisation précédent. Enfin, l'invention concerne également un dispositif radar comportant un émetteur hyperfréquence tel que décrit ci-dessus.

Les lasers ou les émetteurs laser peuvent être assemblés en matrice, un couplage ou une transmission par fibres optiques étant réalisé entre les éléments permettant d'imposer des retards de phase et les moyens pour mélanger les faisceaux émis.

Les moyens d'asservissement en fréquence peuvent être également assemblés en matrice.

Enfin, les moyens pour former un signal de battement peuvent être confondus avec les moyens pour mélanger soit le faisceau émis par le premier laser et chacun des N faisceaux retardés, soit chacun des faisceaux émis par les premiers émetteurs des N paires d'émetteurs laser avec chacun des faisceaux émis par les seconds émetteurs des N paires d'émetteurs laser et retardés par les éléments permettant d'imposer un retard de phase.

Selon un autre aspect les lasers ou les émetteurs laser sont assemblés en matrice et multiplexés par un multiplexeur, une fibre optique reliant le multiplexeur et un démultiplexeur.

Pour cela, on peut réaliser des sources laser décalées en fréquence optique, du pas du multiplexage. A cette fin, on réalise un ajustement de la longueur de la cavité : à chaque cavité laser est, par exemple associé un miroir de type réseau de Bragg réalisé sur un guide correspondant du multiplexeur.

L'invention concerne donc également un dispositif optique comportant :

- des lasers ou des émetteurs laser (microlasers ou diodes laser) réalisés en mosaïque ou en matrice,
- un dispositif de multiplexage comportant des guides optiques intégrées, chaque guide optique correspondant par exemple à une source laser ou à un émetteur laser ou à une cavité laser,
- un miroir de type réseau de Bragg, réalisé (par exemple : gravé) sur chaque guide du dispositif de multiplexage.

## BRÈVE DESCRIPTION DES FIGURES

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :

- la figure 1 illustre le principe du transport optique de signaux hyperfréquences avec deux lasers,
- la figure 2 représente schématiquement le principe d'une antenne active,
- les figures 3A et 3B représentent un exemple utile à la compréhension de l'invention,
- la figure 4 représente un dispositif électro-optique,
- la figure 5 représente une matrice de déphaseurs,
- les figures 6A et 6B représentent un mode de réalisation de l'invention, avec une matrice de paires d'émetteurs, les moyens associés de modulation de phase eux aussi en structure matricielle, et le schéma d'asservissement en fréquence des émetteurs,
- la figure 7 représente des moyens pour l'asservissement de phase du signal d'un dispositif selon l'invention,
- la figure 8a représente un modulateur électrooptique intracavité,
- la figure 8B représente des sources microlaser asservies en écart de phase, par dérive de fréquence,
- la figure 9 représente l'asservissement en fréquence du dispositif de la figure 8B,
- la figure 10 représente un radar à antenne active fonctionnant en hétérodynage optique, avec sources microlaser,
- la figure 11 représente une cavité microlaser munie d'un modulateur électro-optique et associée à un analyseur,
- la figure 12 représente un dispositif selon l'invention, avec un multiplexage de longueurs d'onde pour réduire le nombre de canaux de fibres optiques,
- les figures 13A et 13B représentent des microlasers munis de miroirs de type réseau.

## EXPOSÉ DÉTAILLÉ DE MODES DE RÉALISATION DE L'INVENTION

Un exemple utile à la compréhension de l'invention va être exposé en liaison avec la figure 3A.

Deux lasers 22, 24 émettent à deux fréquences différentes : $\Omega$ et $\Omega+\omega$. Sur le trajet de l'un d'entre eux sont disposés des moyens 52, 54, 56, 58 pour engendrer des retards de phase. Les faisceaux laser sont transmis par des fibres 42, 44, 46, 48, 50 jusqu'à des mélangeurs (photodétecteurs optiques) 26, 28, 30, 32. Les parties 34, 36, 38, 40, situées au-delà des mélangeurs constituent les antennes.

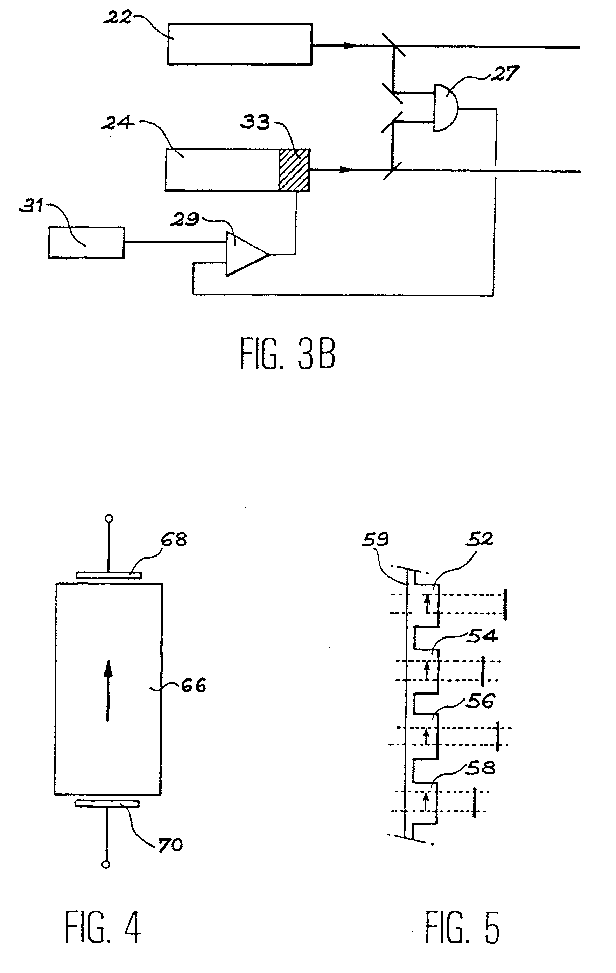

Les deux sources laser 22, 24 sont asservies en fréquence. L'asservissement est représenté schématiquement par la référence 25 sur la figue 3A. Plus précisément, il comporte (figure 3B) une photodiode 27 qui reçoit une portion de chacun des faisceaux émis par les lasers 22, 24 et qui produit un signal de battement qui sert de signal d'entrée d'un comparateur 29. Une source hyperfréquence 31 de référence délivre son signal sur l'autre entrée du comparateur 29. Celui-ci produit un signal de sortie utilisé pour contrôler la fréquence du laser 24, par exemple en contrôlant un élément 33 de réglage de la longueur optique de la cavité du laser 24. Un tel élément est par exemple du type électro-optique ou magnéto-optique.

Un élément électro-optique 60 est représenté en figure 4. On lui applique une tension par des électrodes 68, 70. Le trajet optique du faisceau laser est modifié par l'application d'une tension entre les électrodes 68, 70. En effet, il en résulte un champ E et un indice $n_{eE} = n_e - \frac{r_{33} n_e^2 E}{2}$, où $n_e$ est l'indice du matériau 66 en l'absence de champ, $r_{33}$ est le coefficient électro-optique, et E est le champ appliqué.

Il en résulte, ainsi, une modification de la longueur optique de la cavité du laser, donc de sa fréquence d'émission.

Le matériau électro-optique 66 est, typiquement, du $LiNbO_3$ ou du $LiTaO_3$ ou n'importe quel matériau présentant une variation significative de son indice sous l'action d'un champ électrique (éventuellement un semi-conducteur).

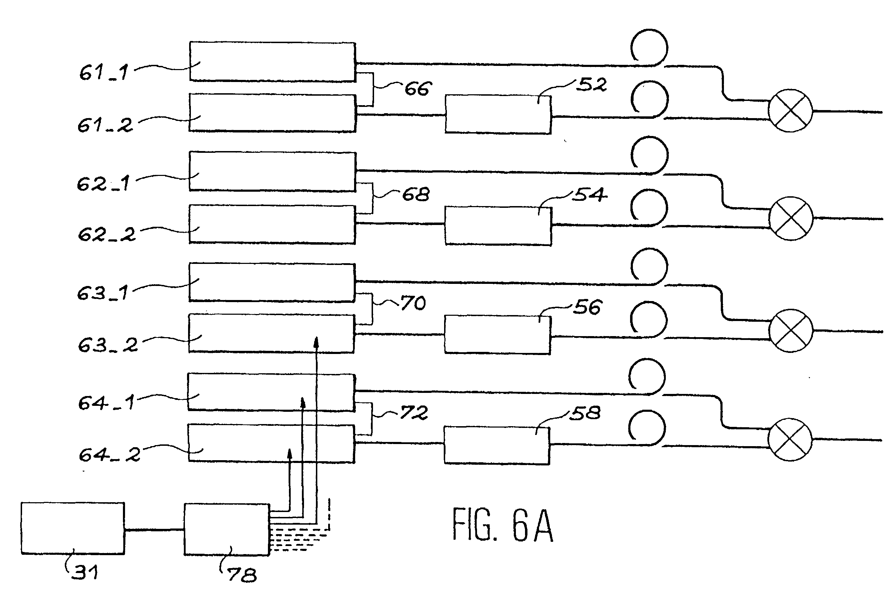

Les moyens 52, 54, 56, 58 sont réalisés sous forme de barrette ou de matrice. Ces moyens peuvent être du type magnéto-optique ou électro-optique. La figure 5 représente quatre éléments électro-optiques 52, 54, 56, 58 disposés sur un support 59 (transparent à la longueur d'onde souhaitée), sur lequel ils sont par exemple collés. Les matériaux électro-optiques sont, par ailleurs, compatibles avec une réalisation collective. Les technologies de fabrication en "wafer" permettent d'obtenir simplement, par (poli)-sciage, les géométries des modulateurs en barrettes ou en matrices sur leur support 59 : il n'y a alors plus besoin d'étapes de collage.

Selon un mode de réalisation particulier, l'invention met en oeuvre des lasers "puces", ou microlasers. La structure des microlasers va d'abord être rappelée.

Elle est exposée, par exemple, dans l'article de J.L. Aubert, intitulé "Q-switched microchip lasers bring new applications to light" paru dans "Laser Focus World", Juin 1995.

Le laser puce est un laser solide pompé par diode via, ou non, une fibre optique. Tous les éléments constitutifs du laser (milieu à gain, miroirs, modulateurs, ...) sont intégrés dans un faible volume (< $mm^3$) pour former un ensemble monolithique compact. Les miroirs du laser sont par exemple directement apposés sur le matériau laser, qui est diélectrique.

De façon classique, le matériau laser, constitutif du milieu actif est dopé au néodyme (Nd) pour une émission laser autour de 1,06 µm. Ce matériau peut être choisi, par exemple, parmi l'un des matériaux suivants : YAG ($Y_3Al_5O_{12}$), LMA ($LaMgAl_{11}O_{19}$), $YVO_4$, YSO ($Y_2SiO_5$), YLF ($YLiF_4$) ou $GdVO_4$, etc. Ce peut être aussi un verre.

Pour des émission à d'autres longueurs d'ondes on choisit des dopants différents. En général, les ions actifs sont choisis parmi :

- Nd pour une émission autour de 1,06 µm (1,064 µm), ainsi qu'autour de 1,3 µm,
- Er ou un codopage erbium-ytterbium Er+Yb pour une émission autour de 1,5 µm,
- Tm ou Ho ou un codopage de thulium et d'holmium pour une émission autour de 2 µm.

Suivant la nature du matériau laser et du dopage, diverses longueurs d'ondes d'émission sont donc possibles. Les deux longueurs d'onde 1,3 µm et 1,5 µm sont intéressantes pour l'application au transport hyperfréquence par voies optiques, car elle sont situées dans les fenêtres identifiées pour les applications aux télécommunications optiques (disponibilité de composants spécifiques assurée par ce marché).

Divers développements spécifiques (cavités stables, modulation de fréquence, ...), ont été réalisées autour de la structure de base des microlasers.

En particulier, le document EP-653 824 décrit un microlaser à déclenchement passif pour absorbant saturable. Le document EP-724 316 décrit un microlaser solide monolithique à déclenchement actif par tension de commande faible.

Les documents cités ci-dessus donnent également des procédés de réalisation des microlasers. Ces procédés sont collectifs et permettent de réaliser de nombreux microlasers simultanément.

En particulier, on peut réaliser des barrettes ou des matrices de microlasers : il suffit, pour cela, de modifier l'étape de découpage dans le procédé collectif de réalisation.

Ces microlasers peuvent être incorporés dans un dispositif du type décrit ci-dessus en liaison avec la figure 3A. La structure des microlasers en matrice est compatible avec la structure matricielle des moyens 52, 54, 56, 58.

On peut aussi utiliser au lieu des microlasers, des matrices de VCSEL (lasers semiconducteurs à cavité verticale) qui peuvent eux aussi donner lieu à une réalisation en matrices ou en barrettes.

Dans tous les cas, l'utilisation d'émetteurs laser en matrices ou en barrettes, en combinaison avec les moyens de retard de phase, eux-mêmes réalisés en matrices ou en barrettes, permet d'obtenir un dispositif émetteur d'hyperfréquences très compact, donc compatible avec les applications (par exemple, les applications de type "radar") où un très grand nombre d'émetteurs est requis.

Le modulateur de phase décrit précédemment est positionné "en aval" de deux sources asservies en écart de fréquence. Il peut aussi être avantageusement utilisé en aval d'un ensemble de plusieurs paires d'émetteurs pour autant que ceux-ci soient asservis en phase (asservissement lent, pouvant être obtenu de diverses manières : par exemple thermiquement ou électro-optiquement, comme décrit plus loin). Dans ce cas, la topologie du système est celle schématisée sur la figure 6A, un des deux faisceaux de chaque paire de sources traversant un élément de retard de phase 52, 54, 56, 58. Chaque paire est asservie en fréquence de la manière décrite ci-dessus en liaison avec la figure 3B, la source hyperfréquence de référence pouvant être commune à toutes les paires d'émetteurs.

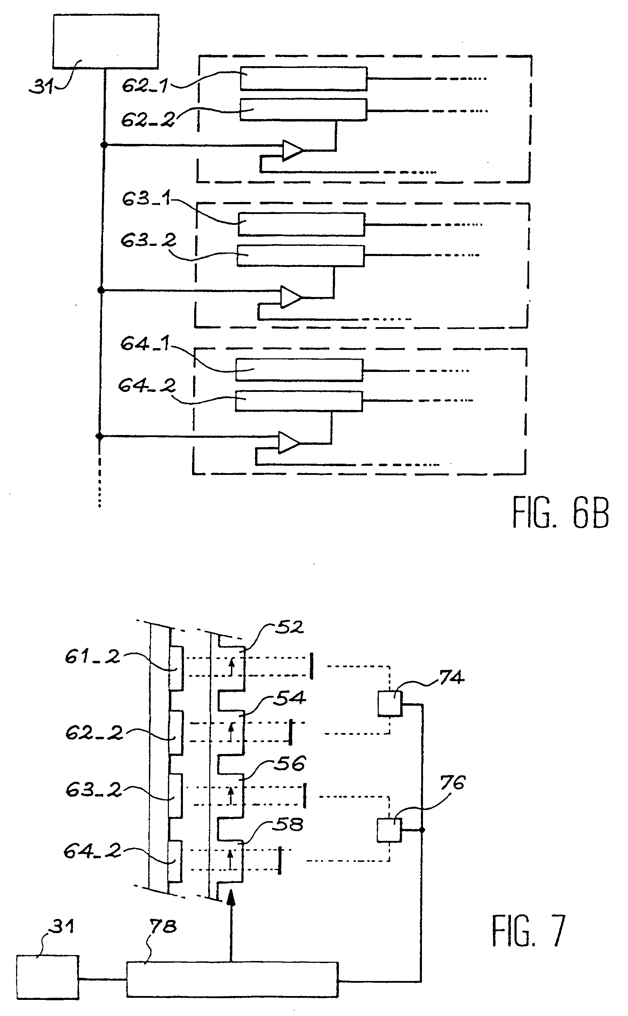

Une matrice d'émetteurs 61-2, 62-2, 63-2, 64-2 (les émetteurs 61-1, 62-1, 63-1, 64-1 ne sont pas représentés) en "wafer", avec des moyens associés 52, 54, 56, 58 de modulation de phase, eux aussi en structure matricielle, est illustrée sur la figure 7.

D'un point de vue pratique cette topologie a l'avantage de fournir, par la parallélisation des sources, une puissance optique - ou hyperfréquence - plus importante, tout en conservant une configuration d'ensemble matricielle.

Plus précisément, la fonction d'asservissement comporte, comme illustré sur les figures 6A et 6B, deux niveaux :

1) un premier asservissement 66, 68, 70, 72, d'écart de fréquence des sources optiques, calé sur une source de référence hyperfréquence ; ce premier niveau d'asservissement a déjà été décrit ci-dessus (figure 3B).

2) un second asservissement, de l'écart de phase des sources optiques entre elles, réalisé par l'utilisation pour les différentes paires de microlasers, d'une source hyperfréquence 31 de référence commune.

Cette source hyperfréquence 31 envoie un signal de référence commun à toutes les paires 62-1, 62-2, 63-1, 63-2, 64-1, 64-2 de microlasers.

Le signal résultant peut lui-même être contrôlé de manière à pouvoir moduler la direction du plan 23 de l'onde émise (voir figure 2). A cette fin (figure 7), des photodiodes 74, 76 prélèvent les signaux issus, par exemple, de paires de modulateurs voisins 56, 58 ou 52, 54 pour former un signal de battement à partir des faisceaux de paires de microlasers. Chacun de ces signaux est envoyé à des moyens 78 qui détectent l'écart de fréquence et de phase avec la source de référence 31 et corrigent cet écart par la commande en tension de chacun des modulateurs électro-optiques.

Le même type d'asservissement peut être utilisé pour le dispositif de la figure 3A. Mais, c'est moins nécessaire car la rotation de phase est alors imposée par les deux sources. La commande de phase peut donc être appliquée, dans ce cas, sans asservissement.

Une variante de la figure 6A consisterait à disposer un élément de retard de phase pour chaque faisceau de chaque paire de source, par exemple un retard de phase de +φ/2 sur le trajet des faisceaux issus des sources 61-1, 62-1, 63-1 et 64-1 et un retard de -φ/2 sur les trajets des faisceaux issus des sources 61-2, 62-2, 63-2, 64-2. On peut réaliser, plus généralement, un déphasage symétrique et différentiel sur les deux voies.

Dans les modes de réalisation décrits ci-dessus, les sources sont considérées comme fixes en fréquence et en phase (par asservissement). On peut modifier la phase des multiples émetteurs hyperfréquences en faisant glisser (pendant un court instant) la fréquence relative de chacune des paires d'émetteurs. L'avantage, pour la modulation de phase, de cette approche par dérive de fréquence réside dans la possibilité d'une modification de la phase dans des valeurs bien supérieures à +/-π (contrairement à la modulation directe).

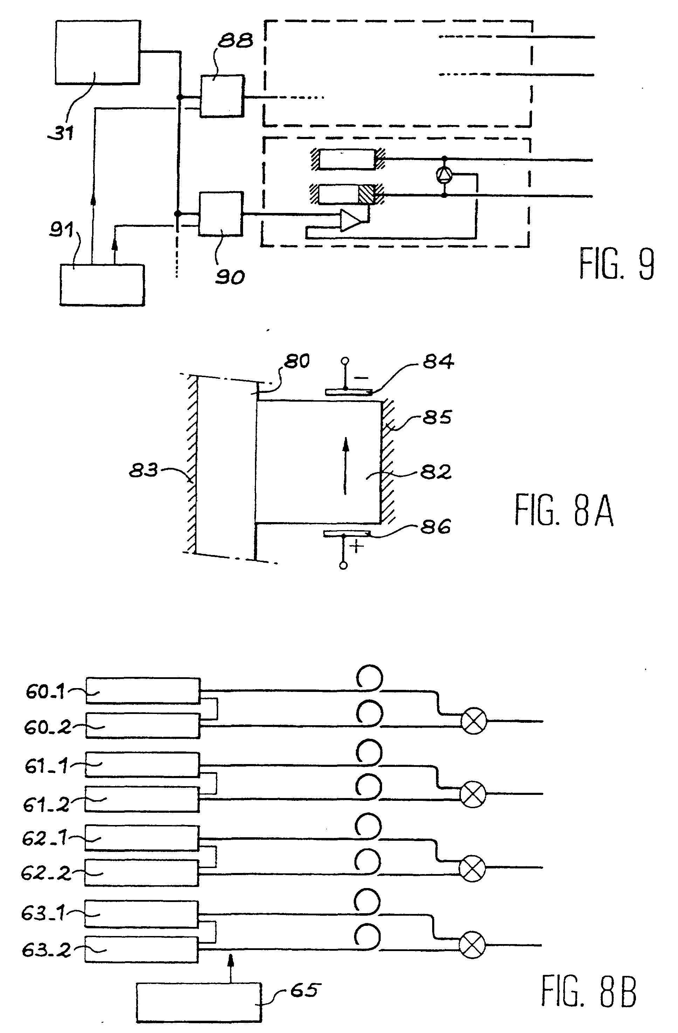

La "dérive" en fréquence optique des lasers peut être obtenue, comme schématisé sur la figure 8A, par modification de la longueur optique de leur cavité. Cette modification de longueur optique est par exemple obtenue par effet électro-optique du type de ceux déjà mentionnés précédemment. Le milieu actif laser 80 et le matériau électrooptique 82 font tous deux partie de la cavité microlaser délimitée par les miroirs 83, 85 de cavité. Là encore les composants optiques microlaser avec modulateur sont compatibles avec une réalisation collective. L'application d'une tension entre les électrodes 84, 86 entraîne une variation d'indice du matériau électrooptique 82, donc de la longueur optique de la cavité microlaser.

Il en résulte une variation de la fréquence d'émission du laser. Pratiquement, le système présente la structure globale représentée sur la figure 8B, structure dans laquelle un élément électro-optique sur le trajet des faisceaux laser n'apparaît plus : on impose une relation de phase entre deux sources laser en faisant glisser la fréquence de l'un des lasers jusqu'à ce que l'écart de phase souhaité soit atteint. On peut, par exemple, disposer sur chaque voie (voir figure 9) des moyens 88, 90 pour imposer un retard de phase du signal hyperfréquence de référence. Le "glissement" de la phase de la référence entraîne un glissement de la fréquence du laser (puisqu'on modifie le signal de référence du comparateur correspondant), donc un glissement de la phase d'un laser par rapport à l'autre. La commande de glissement de fréquence peut par exemple être obtenue par une bande à verrouillage de phase (PLL) commandée par une centrale de commande d'orientation d'antenne 91.

Sur la figure 8B, la référence 65 désigne un dispositif fournissant une référence de phase.

On cherche à diminuer, autant que faire se peut, la tension de commande du dispositif 82 de la figure 8A en rapprochant les électrodes 84, 86. Dans le cas représenté (d'une configuration de modulation transversale à l'axe du laser), la section droite du faisceau laser peut ainsi être réduite par l'emploi d'une configuration de cavité laser dite stable. Une valeur typique de la tension de modulation - pour le cas de cristaux - est alors de 10 Mhz/V.

On peut avantageusement remplacer chaque paire de sources de rayonnement par une source bifréquence. L'asservissement en fréquence et en phase est alors le même que celui décrit ci-dessus, mais le dispositif obtenu est encore plus compact et l'asservissement est moins contraint car toute dérive sur la cavité des lasers agit au deuxième ordre sur l'écart de fréquence des doubles émetteurs. Des sources laser bifréquences sont décrites dans l'article de M. Brunel et al. déjà cité ci-dessus.

Par ailleurs, la figure 8 a donné l'exemple d'une modulation électro-optique. On peut aussi mettre en oeuvre une modulation par semi-conducteur, avec l'avantage d'une bande passante de modulation intrinsèquement plus élevée que celle obtenue avec des cristaux électro-optiques. De plus, on obtient alors une géométrie planaire et plus compacte.

Une autre application de l'invention concerne les systèmes radar.

La technologie de fabrication collective des modulateurs de phase est intéressante - pour l'application radar - par l'aspect matriciel de la structure qu'elle permet d'obtenir. Par ailleurs, la technologie de fabrication collective des microlasers est elle aussi intéressante en vue de cette application. Cette structure de sources (avec modulation de phase externe ou interne à la cavité) peut être complétée par des fonctions système comme, par exemple, celles d'asservissement de la fréquence, de gestion des phases par rapport à un signal de référence, ou de la connectique aux fibres optiques de transport de l'information hyperfréquences. On aboutit finalement à un système constitué de la superposition de multiples "tranches" à vocation optique ou électronique, extrêmement compact malgré la complexité visée (asservissement de plusieurs milliers d'émetteurs hyperfréquences).

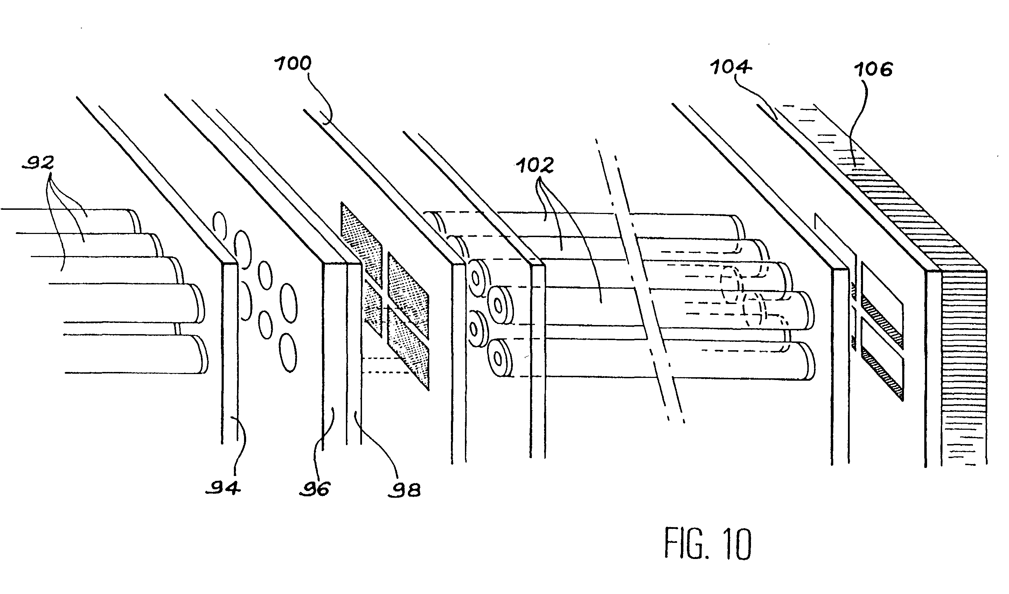

La figure 10, représente schématiquement un système radar basé sur la mise en matrice des voies opto-hyper. Une variante avec barrettes peut être réalisée pour optimiser les coûts de fabrication.

Le dispositif représenté comporte des moyens 92 de couplage de fibres 94 véhiculant des faisceaux de pompage issus d'une matrice de diodes de pompage (non représentées sur la figure 10). Les faisceaux de pompage sont ensuite dirigés vers une matrice 96 de lasers puce (ou microlasers ou VCSEL) munie d'une matrice 98 de moyens de modulation de phase et/ou d'amplitude. La référence 100 désigne une matrice de moyens d'action sur l'asservissement de phases et/ou d'amplitude des lasers puce. Les moyens d'asservissement de phase sont par exemple des moyens du type de ceux déjà décrits ci-dessus.

En particulier, des consignes de phase et/ou d'amplitude sont réglées par des signaux de battement provenant de diodes qui peuvent se situer soit sur le trajet des faisceaux laser (en amont des fibres optiques) soit en fin de chaîne, les diodes d'asservissement étant alors confondues avec les diodes d'antenne de la matrice 104. Cette deuxième possibilité permet de tenir compte de retards de phase liés aux fibres optiques 102. Le signal de battement est dans tous les cas renvoyé aux moyens d'asservissement de la matrice 100. Dans le deuxième cas, il peut être renvoyé par les fibres 102 ou par des fibres optiques séparées. Les fibres optiques 102 permettent de transporter les faisceaux modulés à une matrice 104 de photodiodes, qui ont une fonction de mélange de faisceaux. Ce sont des moyens de détection de signaux de battement en vue de l'asservissement de phases et/ou d'amplitudes. La référence 106 désigne une matrice d'antennes actives munie d'une amplification électronique adéquate.

L'ajustement en amplitude des différents émetteurs peut être réalisé par modulation de la puissance de pompe des lasers. Les performances en fréquence de modulation sont cependant alors limitées (< quelques 100 kHz) pour des raisons inhérentes au matériau laser (durée de vie de niveaux, en particulier).

La modulation d'amplitude des sources est donc de préférence réalisée par modulation électro-optique. Une description de ce type de modulation est donnée dans l'ouvrage de A. Orszag et G. Heppner intitulé "Les lasers et leurs applications" Masson, p.1450, 1980.

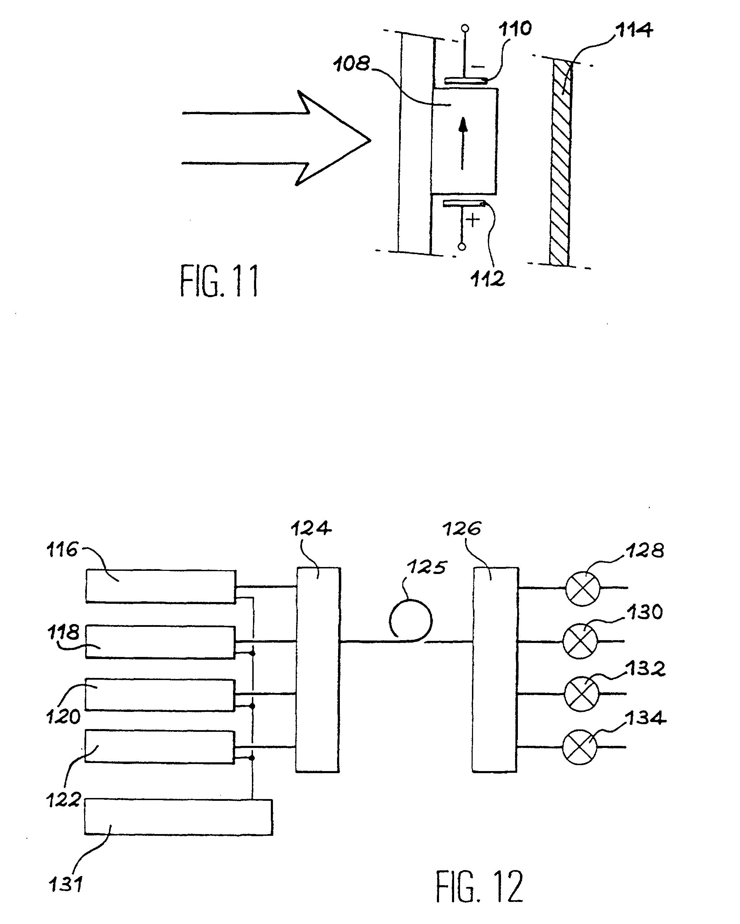

Comme illustrée sur la figure 11, un modulateur électro-optique repose sur le changement de direction de polarisation d'une onde lumineuse à la traversée d'un milieu anisotrope 108, en fonction d'un champ électrique extérieur appliqué à l'aide d'électrodes 110, 112. Ce changement de direction de polarisation - analysé au moyen d'un polariseur linéaire 114 - se traduit par une modulation d'amplitude du signal optique.

De préférence, l'analyseur 114 est assemblé sur le matériau électro-optique 108.

Dans l'hypothèse où l'onde laser n'est pas parfaitement polarisée en entrée du modulateur, un polariseur (analogue à celui de l'analyseur) peut être implanté en amont du modulateur.

Par conséquent, la figure 10 décrit la structure d'ensemble d'un radar à antenne active fonctionnant en hétérodynage optique. Les moyens de contrôle ou de modulation de phase et/ou d'amplitude peuvent être situés en amont du transport par fibres otiques des signaux hyperfréquence. Ils peuvent aussi (c'est le cas représenté sur la figure 10) être positionné de manière répartie entre l'amont et l'aval du réseau de fibres : en amont des fibres, on trouve alors les moyens d'action sur la phase et l'amplitude des ondes ; en aval, les moyens de détection de l'écart à la "consigne d'asservissement", cette consigne, ainsi que l'écart à cette consigne, pouvant être avantageusement transmis(e) par le réseau de fibres.

Dans la structure du système décrit ci-dessus en liaison avec la figure 10, apparaissent autant de fibres optiques que de voies hyperfréquence à réaliser (soit par exemple 2000 dans une configuration "objectif"). Il est possible de réduire le nombre de ces fibres par multiplexage de longueurs d'onde (comme cela se fait en télécommunication avec des multiplexeurs, de type "Phasar" par exemple).

Pour cela, on réalise des sources laser puce décalées en fréquence optique du pas de multiplexage (typiquement 0,8 nm), par ajustement, par exemple, de leur longueur de cavité.

Sur la figure 12 est schématisée cette approche avec la mise en oeuvre de sources laser puce bifréquence : le microlaser 116 émet aux fréquences $\Omega_1$ et $\Omega_1+\omega$, le microlaser 118 fréquences $\Omega_2$ et $\Omega_2+\omega$ ... etc. La référence 124 désigne un multiplexeur optique et la référence 126 un démultiplexeur.

Une référence de phase peut être obtenue pour chacun des microlasers, comme déjà décrit précédemment. Un moyen pour fournir une référence de phase est indiqué sur la figure 12 par la référence 131. Chacun des faisceaux démultiplexés est ensuite détecté par un photodétecteur 128, 130, 132, 134.

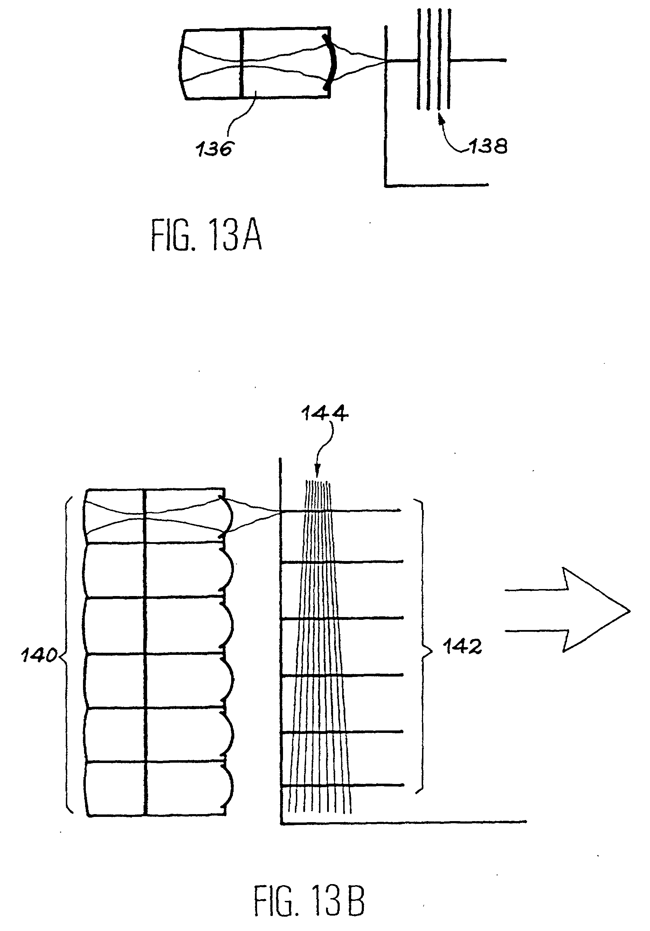

D'un point de vue pratique, l'ajustement des longueurs des différentes cavités peut être réalisée par une cavité "distribuée". Comme illustré sur la figure 13A, à chaque cavité laser 136 est associé un miroir 138 de type réseau de Bragg, avantageusement réalisé sur le guide correspondant (en optique intégrée) du dispositif de multiplexage. La figure 13B représente un ensemble 140 de microlasers, les guides d'onde 142 correspondant et le réseau 144 gravé sur les guides d'onde. Des diodes laser sont compatibles avec ce schéma, en remplacement des microlasers. Mais le couplage des microlasers est plus aisé à réaliser et, par ailleurs, les microlasers sont plus purs spectralement. Enfin, on peut aussi utiliser des lasers bifréquences.

L'invention concerne donc également un dispositif optique comportant :

- des lasers ou des émetteurs laser (microlasers ou diodes laser) réalisés en mosaïque ou en matrice,
- un dispositif de multiplexage comportant des guides optiques intégrées, chaque guide optique correspondant par exemple à une source laser ou à un émetteur laser ou à une cavité laser,

- un miroir de type réseau de Bragg, réalisé (par exemple : gravé) sur chaque guide du dispositif de multiplexage.

## Revendications

1. Dispositif émetteur d'hyperfréquences, comportant :

   - une pluralité de N paires d'émetteurs laser (61-1, 61-2 ; 62-1, 62-2 ; 63-1, 63-2 ; 64-1, 64-2), réalisés en mosaîque ou en matrice ou en barrette, chaque paire d'émetteurs laser comportant un premier et un second émetteurs laser émettant à une première et une deuxième fréquences $\omega_1$, $\omega_2$, différentes,
   - une mosaïque ou une matrice ou une barrette de N éléments (52, 54, 56, 58), chacun d'entre eux étant disposé sur le trajet du second émetteur laser d'une desdites paires d'émetteurs laser, et chaque élément permettant d'imposer un retard de phase au faisceau dudit second émetteur laser,
   - des moyens (31, 78) d'asservissement, en fréquence et en phase et éventuellement en amplitude de chaque paire d'émetteurs laser,
   - N moyens pour mélanger chacun des faisceaux émis par les premiers émetteurs des N paires d'émetteurs laser avec chacun des faisceaux émis par les seconds émetteurs des N paires d'émetteurs laser et retardés par les éléments permettant d'imposer un retard de phase, et pour produire, N signaux à la fréquence $\omega_1 - \omega_2$,
   - N moyens formant antenne pour émettre un rayonnement à la fréquence $\omega_1 - \omega_2$.

2. Dispositif selon la revendication 1, les émetteurs laser étant des microlasers.

3. Dispositif selon la revendication 1 ou 2, les éléments permettant d'imposer un retard de phase étant des éléments électro-optiques ou magnéto-optiques, ou thermo-optique.

4. Dispositif selon l'une des revendications 1 à 3, les moyens d'asservissement en fréquence comportant des moyens pour former un signal de battement des faisceaux émis par les premier et second lasers de chaque paire d'émetteurs laser, et des moyens pour ajuster la fréquence d'émission d'un des émetteurs laser de la paire d'émetteurs laser en fonction du signal de battement.

5. Dispositif selon la revendication 4, les moyens pour ajuster la fréquence d'émission d'un des lasers en fonction du signal de battement comportant des moyens pour réaliser une comparaison entre le signal de battement et un signal de référence fourni par une source de référence, et des moyens pour modifier la longueur optique de la cavité de l'émetteur laser dont la fréquence d'émission est à ajuster.

6. Dispositif selon la revendication 5, la source de référence étant commune à toutes les paires d'émetteurs laser.

7. Dispositif selon l'une des revendications 1 à 6 comportant en outre des moyens pour asservir le retard imposé par au moins un des éléments de la matrice, ou barrette, de N éléments de retard de phase en fonction d'un signal de battement entre le faisceau qui traverse ledit élément de retard de phase de la matrice et un autre faisceau.

8. Dispositif émetteur d'hyperfréquences, comportant :

   - une pluralité de N paires d'émetteurs laser (60-1, 60-2 ; 61-1, 61-2 ; 62-1, 62-2 ; 63-1, 63-2 ; 64-1, 64-2), réalisés en mosaïque ou en matrice ou en barrette, chaque paire d'émetteur laser comportant un premier et un second émetteurs laser émettant à une première et une deuxième fréquences $\omega_1$, $\omega_2$, différentes,
   - des moyens pour asservir en fréquence chaque paire d'émetteurs laser,
   - des moyens pour modifier la fréquence d'un des émetteurs laser d'au moins une paire d'émetteur laser par rapport à la fréquence de l'autre émetteur laser de ladite paire d'émetteurs laser,
   - N moyens pour mélanger chacun des faisceaux émis par les premiers émetteurs des N paires d'émetteurs laser avec chacun des faisceaux émis par les seconds émetteurs des N paires d'émetteurs laser et pour produire un signal à la fréquence $\omega_1 - \omega_2$,
   - N moyens formant antenne pour émettre un rayonnement à la fréquence $\omega_1 - \omega_2$.

9. Dispositif selon la revendication 8, les émetteurs laser étant des microlasers.

10. Dispositif selon la revendication 8, les premier et second émetteurs laser de chaque paire étant constitués par une source bifréquence, émettant aux deux fréquences $\omega_1$, et $\omega_2$.

11. Dispositif selon l'une des revendications 8 à 10, les moyens pour modifier la fréquence d'un des émetteurs laser d'au moins une paire d'émetteurs laser par rapport à la fréquence de l'autre émetteur laser de ladite paire d'émetteurs laser comportant un modulateur électro-optique (82, 84, 86).

**12.** Dispositif selon la revendication 11, le modulateur électro-optique étant un modulateur à semi-conducteur.

**13.** Dispositif radar comportant un dispositif émetteur d'hyperfréquences selon l'une des revendications 1 à 7, les lasers ou les émetteurs laser (96, 98) étant assemblés en matrice, un couplage ou une transmission par fibres optiques (102) étant réalisé entre les éléments (100) permettant d'imposer des retards de phase et les moyens (104) pour mélanger les faisceaux émis.

**14.** Dispositif radar comportant un dispositif émetteur d'hyperfréquences selon l'une des revendications 1 à 7, les lasers ou les émetteurs laser étant assemblés en matrice et multiplexés par un multiplexeur (124), une fibre optique (125) reliant le multiplexeur et un démultiplexeur (126).

**15.** Dispositif radar selon la revendication 13 ou 14, les moyens d'asservissement en fréquence étant également assemblés en matrice.

**16.** Dispositif radar selon l'une des revendications 13 à 15 et selon la revendication 4, les moyens pour former un signal de battement étant confondus avec les moyens pour mélanger soit le faisceau émis par le premier laser et chacun des N faisceaux retardés, soit chacun des faisceaux émis par les premiers émetteurs des N paires d'émetteurs laser avec chacun des faisceaux émis par les seconds émetteurs des N paires d'émetteurs laser et retardés par les éléments permettant d'imposer un retard de phase.

**17.** Dispositif selon la revendication 14, les cavités des lasers ou des émetteurs laser étant décalés en fréquence l'une par rapport à l'autre.

**18.** Dispositif selon la revendication 17, les cavités étant décalées en fréquence par ajustement de leur longueur.

**19.** Dispositif selon la revendication 18, à chaque cavité laser étant associée un miroir (138, 144) de type réseau de Bragg, réalisé sur un guide (142) correspondant dû multiplexeur.

**Claims**

**1.** An ultrahigh frequency emitting device, having:

- a plurality of N laser emitter pairs (61-1, 61-2; 62-1, 62-2; 63-1, 63-2; 64-1, 64-2), implemented in a mosaic or an array or a bar, each laser emitter pair having a first and a second laser emitter emitting at a first and a second frequency $\omega_1$, $\omega_2$, which are different,

- a mosaic or an array or a bar of N elements (52, 54, 56, 58), each of them being placed on the path of the second laser emitter of one of said laser emitter pairs, and each element making it possible to impose a phase delay on the beam of said second laser emitter,

- means (31, 78) of slaving each laser emitter pair, frequency-wise and phase-wise and possibly amplitude-wise,

- N means for mixing each of the beams emitted by the first emitters of the N laser emitter pairs with each of the beams emitted by the second emitters of the N laser emitter pairs and delayed by the elements making it possible to impose a phase delay, and for producing N signals at the frequency $\omega_1$-$\omega_2$,

- N antenna-forming means for emitting radiation at the frequency $\omega_1$-$\omega_2$.

**2.** A device according to claim 1, the laser emitters being microlasers.

**3.** A device according to claim 1 or 2, the elements making it possible to impose a phase delay being electro-optical or magneto-optical or thermo-optical elements.

**4.** A device according to one of claims 1 to 3, the frequency slaving means having means for forming a beat signal from the beams emitted by the first and second lasers of each laser emitter pair, and means for adjusting the emission frequency of one of the laser emitters of the laser emitter pair according to the beat signal.

**5.** A device according to claim 4, the means for adjusting the emission frequency of one of the lasers according to the beat signal having means for carrying out a comparison between the beat signal and a reference signal provided by a reference source, and means for modifying the optical length of the cavity of the laser emitter whose emission frequency is to be adjusted.

**6.** A device according to claim 5, the reference source being common to all the laser emitter pairs.

**7.** A device according to one of claims 1 to 6, also having means for slaving the delay imposed by at least one of the elements of the array, or bar, of N phase delay elements according to a beat signal between the beam which passes through said phase delay element of the array and another beam.

8. An ultrahigh frequency emitting device, having:

   - a plurality of N laser emitter pairs (60-1, 60-2; 61-1, 61-2; 62-1, 62-2; 63-1, 63-2; 64-1, 64-2), implemented in a mosaic or an array or a bar, each laser emitter pair having a first and a second laser emitter emitting at a first and a second frequency $\omega_1$, $\omega_2$, which are different,

   - means for slaving each laser emitter pair frequency-wise,

   - means for modifying the frequency of one of the laser emitters of at least one laser emitter pair with respect to the frequency of the other laser emitter of said laser emitter pair,

   - N means for mixing each of the beams emitted by the first emitters of the N laser emitter pairs with each of the beams emitted by the second emitters of the N laser emitter pairs and for producing a signal at the frequency $\omega_1$-$\omega_2$,

   - N antenna-forming means for emitting radiation at the frequency $\omega_1$-$\omega_2$.

9. A device according to claim 8, the laser emitters being microlasers.

10. A device according to claim 8, the first and second laser emitters of each pair being constituted by a dual frequency source, emitting at the two frequencies $\omega_1$-$\omega_2$.

11. A device according to one of claims 8 to 10, the means for modifying the frequency of one of the laser emitters of at least one laser emitter pair with respect to the frequency of the other laser emitter of said laser emitter pair comprising an electro-optical modulator (82, 84, 86).

12. A device according to claim 11, the electro-optical modulator being a semiconductor modulator.

13. A radar device having an ultrahigh frequency emitting device according to one of claims 1 to 7, the lasers or the laser emitters (96, 98) being assembled in an array, a coupling or transmission by optical fibres (102) being implemented between the elements (100) making it possible to impose phase delays and the means (104) for mixing.the emitted beams.

14. A radar device having an ultrahigh frequency emitting device according to one of claims 1 to 7, the lasers or the laser emitters being assembled in an array and multiplexed by a multiplexer (124), an optical fibre (125) connecting the multiplexer and a demultiplexer (126).

15. A radar device according to claim 13 or 14, the frequency slaving means also being assembled in an array.

16. A radar device according to one of claims 13 to 15, and according to claim 4, the beat signal forming means being merged with the means for mixing either the beam emitted by the first laser and each of the N delayed beams, or each of the beams emitted by the first emitters of the N laser emitter pairs with each of the beams emitted by the second emitters of the N laser emitter pairs and delayed by the elements making it possible to impose a phase delay.

17. A device according to claim 14, the cavities of the lasers or of the laser emitters being shifted frequency-wise with respect to one another.

18. A device according to claim 17, the cavities being shifted frequency-wise by adjustment of their length.

19. A device according to claim 18, each laser cavity having associated with it a Bragg grating type mirror (138, 144), implemented on a corresponding guide (142) of the multiplexer.

**Patentansprüche**

1. Mikrowellen-Emissionseinrichtung, umfassend:

   - eine Vielzahl N Laseremissionseinrichtungspaare (61-1, 61-2; 62-1, 62-2; 63-1, 63-2; 64-1, 64-2), realisiert in mosaik-, matrix- oder stabförmiger Anordnung, wobei jedes Laseremissionseinrichtungspaar eine erste und eine zweite Laseremissionseinrichtung umfasst, die mit einer ersten und einer zweiten Frequenz $\omega1$, $\omega2$ emittieren, die unterschiedlich sind,

   - ein Mosaik oder eine Matrix oder einen Stab aus N Elementen (52, 54, 56, 58), jedes von ihnen angeordnet im Weg der zweiten Laseremissionseinrichtung von einem der genannten Laseremissionseinrichtungspaare, wobei jedes Element ermöglicht, dem Strahl des genannten zweiten Laseremissionseinrichtungspaars eine Phasenverzögerung aufzuzwingen,

   - Einrichtungen (31, 78) zur Frequenz-, Phasen- und eventuell Amplitudenregelung jedes Laseremissionseinrichtungspaars,

   - N Einrichtungen zum Mischen jedes der durch die ersten Emissionseinrichtungen der N Laseremissionseinrichtungspaare emittierten Strahlen mit jedem der durch die zweiten Emissionseinrichtungen der N Laseremissionseinrichtungspaare emittierten und durch die Elemente verzögerten Strahlen, die ermöglichen, eine Phasenverzögerung aufzuzwingen, und zum Erzeugen von N Signalen mit der Frequenz ω1-ω2,

- N Antenne-bildende Einrichtungen zum Emittieren einer Strahlung mit der Frequenz ω1-ω2.

2. Vorrichtung nach Anspruch 1, wobei die Laseremissionseinrichtungen Mikrolaser sind.

3. Vorrichtung nach Anspruch 1 oder 2, wobei die Elemente, die ermöglichen; eine Phasenverzögerung aufzuzwingen, elektrooptische oder magnetooptische oder thermooptische Elemente sind.

4. Vorrichtung nach einem der Ansprüche 1 bis 3, wobei die Frequenzregelungseinrichtungen Einrichtungen zur Formung eines Überlagerungssignals der durch den ersten und den zweiten Laser jedes Paars emittierten Strahlen umfassen sowie Einrichtungen zur Justierung der Emissionsfrequenz einer der Laseremissionseinrichtungen des Laseremissionseinrichtungspaars in Abhängigkeit von dem Überlagerungssignal.

5. Vorrichtung nach Anspruch 4, wobei die Einrichtungen zum Justieren der Emissionsfrequenz eines der Laser in Abhängigkeit von dem Übeflagerungssignal Einrichtungen zum Durchführen eines Vergleichs zwischen dem Überlagerungssignal und einem Bezugssignal umfassen, das durch eine Bezugsquelle geliefert wird, sowie Einrichtungen zum Modifizieren der optischen Länge des Resonators der Laseremissionseinrichtungen, deren Emissionsfrequenz zu justieren ist.

6. Vorrichtung nach Anspruch 5, wobei die Bezugsquelle für alle Laseremissionseinrichtungspaare dieselbe ist.

7. Vorrichtung nach einem der Ansprüche 1 bis 6, außerdem Einrichtungen zum Regeln der durch wenigstens eines der Elemente der Matrix, oder des Stabs, aufgezwungenen Verzögerung von N Phasenverzögerungselementen umfassend, in Abhängigkeit von einem Überlagerungssignal zwischen dem Strahl, der das genannte Phasenverzögerungselement der Matrix durchquert, und einem anderen Strahl.

8. Mikrowellen-Emissionsvorrichtung, umfassend:

- eine Vielzahl N Laseremissionseinrichtungspaare (60-1, 60-2; 61-1, 61-2; 62-1, 62-2; 63-1, 63-2; 64-1, 64-2), realisiert in mosaik-, matrix- oder stabförmiger Anordnung, wobei jedes Laseremissionseinrichtungspaar eine erste und eine zweite Laseremissionseinrichtung umfasst, die mit einer ersten und einer zweiten Frequenz ω1, ω2 emittieren, die unterschiedlich sind,

- Einrichtungen zur Frequenzregelung jedes Laseremissionseinrichtungspaars,

- Einrichtungen zum Modifizieren der Frequenz einer der Laseremissionseinrichtungen wenigstens eines Laseremissionseinrichtungspaars in Bezug auf die Frequenz der anderen Laseremissionseinrichtung des genannten Laseremissionseinrichtungspaars,

- N Einrichtungen zum Mischen jedes der durch die ersten Emissionseinrichtungen der N Laseremissionseinrichtungspaare emittierten Strahlen mit jedem der durch die zweiten Emissionseinrichtungen der N Laseremissionseinrichtungspaare emittierten Strahlen, und zum Erzeugen eines Signals mit der Frequenz ω1-ω2,

- N Antenne-bildende Einrichtungen zum emittieren einer Strahlung mit der Frequenz ω1-ω2.

9. Vorrichtung nach Anspruch 8, wobei die Laseremissionseinrichtungen Mikrolaser sind.

10. Vorrichtung nach Anspruch 8, wobei die erste und zweite Laseremissionseinrichtung jedes Paars durch eine Zweifrequenzenquelle gebildet wird, die mit den beiden Frequenzen ω1 und ω2 emittiert.

11. Vorrichtung nach einem der Ansprüche 8 bis 10, wobei die Einrichtungen zum Modifizieren der Frequenz einer der Laseremissionseinrichtungen wenigstens eines Laseremissionseinrichtungspaars in Bezug auf die Frequenz der anderen Laseremissionseinrichtung des genannten Laseremissionseinrichtungspaars einen elektrooptischen Modulator (82, 84, 86) umfasst.

12. Vorrichtung nach Anspruch 11, wobei der elektrooptische Modulator ein Halbleitermodulator ist.

13. Radarvorrichtung, eine Mikrowellen-Emissionseinrichtung nach einem der Ansprüche 1 bis 7 umfassend, wobei die Laser und die Laseremissionseinrichtungen (96, 98) matrixförmig zusammengebaut sind und zwischen den Elementen (100) eine Kopplung oder Transmission durch optische Fasern (102) realisiert ist, was ermöglicht, Phasenverzögerungen aufzuzwingen, und die Einrichtungen (104) zum Mischen der emittierten Strahlen umfassend.

14. Radarvorrichtung, eine Mikrowellen-Emissionseinrichtung nach einem der Ansprüche 1 bis 7 umfassend, wobei die Laser oder die Laseremissionseinrichtungen matrixförmig zusammengebaut sind und durch einen Multiplexer (124) gemultiplext werden, wobei eine optische Faser (125) den Multiplexer und einen Demultiplexer (126) verbindet.

15. Radarvorrichtung nach Anspruch 13 oder 14, wobei die Frequenzregelungseinrichtungen ebenfalls matrixförmig zusammengebaut sind.

16. Radarvorrichtung nach einem der Ansprüche 13 bis 15 und nach Anspruch 4, wobei die Einrichtungen zum Formen eines Überlagerungssignals zusammenfallen mit den Einrichtungen zum Mischen von entweder dem durch den ersten Laser emittierten Strahl und jedem der N verzögerten Strahlen, oder jedem der durch die ersten Emissionseinrichtungen der N Laseremissionseinrichtungspaare emittierten Strahlen mit jedem der durch die zweiten Emissionseinrichtungen der N Laseremissionseinrichtungspaare emittierten und durch die Elemente verzögerten Strahlen, die ermöglichen, eine Phasenverzögerung zu erzwingen.

17. Vorrichtung nach Anspruch 14, wobei die Resonatoren der Laser oder der Laseremissionseinrichtungen gegeneinander frequenzverschoben sind.

18. Vorrichtung nach Anspruch 17, wobei die Resonatoren durch Justierung bzw. Anpassung ihrer Länge frequenzverschoben sind.

19. Vorrichtung nach Anspruch 18, wobei jedem Laserresonator ein Spiegel (138, 144) des Typs Bragg-Gitter zugeordnet wird, hergestellt auf einem Leiter (142) des Multiplexers.

FIG. 1

FIG. 2

FIG. 3 A

FIG. 3B

FIG. 4

FIG. 5

61_1
61_2
66
52
62_1
62_2
68
54
63_1
63_2
70
56
64_1
64_2
72
58
31
78

FIG. 6A

EP 1 031 172 B1

FIG. 6B

FIG. 7

FIG. 9

FIG. 8A

FIG. 8B

FIG. 10

EP 1 031 172 B1

FIG. 11

FIG. 12

FIG. 13A

FIG. 13 B